(19) Europäisches Patentamt / European Patent Office / Office européen des brevets

(11) **EP 2 041 591 B1**

(12) **EUROPÄISCHE PATENTSCHRIFT**

(45) Veröffentlichungstag und Bekanntmachung des Hinweises auf die Patenterteilung:
**04.11.2015 Patentblatt 2015/45**

(51) Int Cl.:
***G01R 31/34*** *(2006.01)*

(21) Anmeldenummer: **07730117.4**

(22) Anmeldetag: **13.06.2007**

(86) Internationale Anmeldenummer:
**PCT/EP2007/055814**

(87) Internationale Veröffentlichungsnummer:
**WO 2008/006655 (17.01.2008 Gazette 2008/03)**

(54) **VERFAHREN UND VORRICHTUNG ZUR DETEKTION VON INTERLAMINAREN KURZSCHLÜSSEN**

METHOD AND DEVICE FOR DETECTING INTERLAMINAR SHORT CIRCUITS

PROCÉDÉ ET DISPOSITIF POUR LA DÉTECTION DE COURTS-CIRCUITS INTERLAMINAIRES

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **13.07.2006 CH 11252006**

(43) Veröffentlichungstag der Anmeldung:
**01.04.2009 Patentblatt 2009/14**

(73) Patentinhaber: **ALSTOM Technology Ltd 5400 Baden (CH)**

(72) Erfinder: **HOBELSBERGER, Max CH-5303 Würenlingen (CH)**

(74) Vertreter: **Alstom Technology Ltd CHTI Intellectual Property Brown Boveri Strasse 7 5400 Baden (CH)**

(56) Entgegenhaltungen:
JP-A- 61 149 873    US-A- 5 032 826
US-B1- 7 034 706

• BURTH M ET AL: "DIAGNOSE VON UNIVERSALMOTOREN MIT HILFE DES STROM- UND VIBRATIONSSIGNALS (TEIL 1)" TECHNISCHES MESSEN TM, R.OLDENBOURG VERLAG. MUNCHEN, DE, Bd. 64, Nr. 1, Januar 1997 (1997-01), Seiten 3-11, XP000691195 ISSN: 0171-8096

**Beschreibung**

**Technisches Gebiet**

Die vorliegende Erfindung betrifft ein Verfahren und eine Vorrichtung zur Detektion von Kurzschlüssen zwischen Statorblechen einer elektrischen Maschine, insbesondere eines elektrischen Generators.

**Stand der Technik**

Grosse Generatoren und Motoren werden routinemässig im Stillstand auf Blechschlüsse (interlaminare Kurzschlüsse) zwischen den normalerweise gegeneinander isolierten Blechen im Blechpaket des Stators hin untersucht. Es ist jedoch wünschenswert, solche Fehler während des Betriebes der Maschine zu detektieren, weil auf diese Weise Blechschlüsse früher erkannt werden können und früher Massnahmen ergriffen werden können, um weitergehende Schäden zu vermeiden.

Aus der US-Patentschrift US 5,032,826 (Miller et al.) ist es bekannt, die Wellen-spannung der Maschine zu messen und daraus Rückschlüsse auf interlaminare Kurzschlüsse zu ziehen. Die Wellenspannung ist jene Spannung, die entlang der Welle, insbesondere zwischen beiden Enden, bzw. zwischen der Welle und Erde während des Betriebes der Elektromaschine auftritt. Gemäss US 5,032,826 werden Änderungen der Wellenspannung im Frequenzbereich oder im Zeitbereich als Hinweis auf Interlaminarschäden gedeutet.

Nachteilig bei dem genannten Verfahren ist der Umstand, dass nicht angegeben wird, welche Änderungen der Wellenspannung als Hinweis auf Schäden gewertet werden sollen. Die Interpretation der Messergebnisse ist damit meist nicht eindeutig. Dafür gibt es unter anderem folgende Gründe:

- Die Kurvenform der Wellenspannung hängt vom Lastzustand der Maschine ab: Je nach Lastzustand liegt ein anderes Spektrum vor bzw. ändert sich die Kurvenform der Wellenspannung.
- Die durch normale Interlaminar-Kurzschlüsse verursachten Änderungen der Wellenspannung sind klein in Relation zu der normalen Wellenspannung, die ohne Blechschluss auftritt. Somit sind diese Änderungen schwer zu detektieren, die Detektion ist nicht zuverlässig.
- Aufgrund schlechter Kontakte zwischen Kontaktbürsten und Welle werden die Messergebnisse oft verfälscht, da das Spektrum der gemessenen Wellenspannung stark von der Kontaktgüte abhängt.

**Darstellung der Erfindung**

Es ist daher eine Aufgabe der vorliegenden Erfindung, ein Verfahren zur Detektion von interlaminaren Kurzschlüssen anzugeben, mit welchem derartige Kurzschlüsse mit einer grösseren Sicherheit erkannt werden können. Es ist eine weitere Aufgabe der vorliegenden Erfindung, eine Vorrichtung zu diesem Zweck anzugeben.

Diese Aufgaben werden durch ein Verfahren nach Anspruch 1 bzw. eine Vorrichtung nach Anspruch 15 gelöst. Vorteilhafte Ausgestaltungen sind in den abhängigen Ansprüchen angegeben.

Bei dem erfindungsgemässen Verfahren handelt es sich also um ein Verfahren zur Ermittlung von Kurzschlüssen zwischen Statorblechen einer elektrischen Maschine, welche einen auf einer Welle rotierenden Rotor und einen Stator aufweist, der von einem zeitlich veränderlichen magnetischen Statortluss durchsetzt wird. Die elektrische Maschine kann insbesondere ein Motor oder ein Generator sein, z.B. ein grosser Generator, wie er in Kraftwerken Einsatz findet. Bei dem Verfahren wird im Betrieb der elektrischen Maschine eine Messgrösse ermittelt, die auf einen Kurzschlussstrom zwischen mindestens zwei Statorblechen empfindlich ist. Ein solcher Kurzschlussstrom (Wirbelstrom) entsteht durch den zeitlich veränderlichen magnetischen Statorfluss, der die Stelle des Kurzschlusses durchsetzt. Das Verfahren zeichnet sich dadurch aus, dass der magnetische Statorfluss (bzw. mindestens eine Grösse, die für diesen Statorfluss charakteristisch ist) durch Messung und/oder Berechnung ermittelt wird und dass die Messgrösse oder eine daraus abgeleitete Hilfsgrösse mit einem theoretischen Modell verglichen wird, das einen Zusammenhang zwischen diesem magnetischen Statorfluss und der Messgrösse oder der Hilfsgrösse herstellt. Aus dem Vergleich wird ein Mass für einen Kurzschluss ermittelt.

Ein Grundgedanke der vorliegenden Erfindung liegt also darin, zunächst das Verhalten der Messgrösse beim Vorliegen eines Kurzschlusses zu verstehen und daraus ein theoretisches Modell für die Messgrösse herzuleiten, das die Messgrösse in Abhängigkeit vom Statorfluss beschreibt. Das theoretische Modell schlägt sich in der Regel in einer oder mehreren Gleichungen nieder. Die gemessenen Werte der Messgrösse werden nun mit diesem erwarteten Verhalten verglichen, z.B. indem ein mathematischer Fit der Gleichungen an die Messergebnisse vorgenommen wird, und aus dem Vergleich werden Rückschlüsse auf das Vorliegen oder die Abwesenheit eines Kurzschlusses gezogen. Auf diese Weise kann ein Kurzschluss sehr zuverlässig detektiert und quantifiziert werden.

Unter einem theoretischen Modell ist im Zusammenhang mit der vorliegenden Erfindung ein System von einer oder mehreren Relationen (z.B. Gleichungen, Ungleichungen, numerischen Beziehungen usw.) zu verstehen, die einen Zusammenhang zwischen dem Statorfluss oder bestimmten Anteilen des Statorflusses und der Messgrösse oder einer aus der Messgrösse ableitbaren Hilfsgrösse bzw. bestimmten Anteilen hiervon herstellen.

Die Messgrösse kann z. B. die Wellenspannung sein. Es kann sich jedoch auch um eine andere Grösse handeln, die sich beim Vorliegen eines Kurzschlussstroms in charakteristischer Weise verändert, z. B. ein Ringfluss um die Welle oder eine durch einen solchen Ringfluss induzierte Spannung in einer geeigneten Messschleife.

Als Mass für den Kurzschluss können verschiedene Grössen aus dem Vergleich ermittelt werden. Im einfachsten Fall handelt es sich um ein Mass für die Wahrscheinlichkeit des Vorliegens eines Kurzschlusses. Abhängig vom verwendeten theoretischen Modell kann jedoch auch ein Mass für die Grösse des Kurzschlusses und/oder die räumliche Position des Kurzschlusses im Stator bestimmt werden.

Vorzugsweise findet der Vergleich mit dem theoretischen Modell im Frequenzraum statt. Hierzu werden spektrale Anteile der Messgrösse oder der daraus abgeleiteten Hilfsgrösse bei (vorzugsweise ganzzahligen) Vielfachen der Rotationsfrequenz ermittelt, und es werden diese spektralen Anteile mit einem theoretischen Modell verglichen, welches einen Zusammenhang zwischen dem Statorfluss bzw. dessen spektralen Anteilen und den spektralen Anteilen der Messgrösse bzw. Hilfsgrösse herstellt.

In einer bevorzugten Ausführungsform wird, für mehrere ganzzahlige Vielfache (Harmonische) der Rotationsfrequenz, eine Übertragungsfunktion zwischen einem spektralen Anteil des magnetischen Statorflusses und einem spektralen Anteil der Messgrösse bzw. der daraus abgeleiteten Hilfsgrösse beim gleichen Vielfachen der Rotationsfrequenz ermittelt. Diese Übertragungsfunktionen werden dann mit einem theoretischen Modell der Übertragungsfunktionen verglichen. Beispielsweise kann das theoretische Modell Aussagen über die Abhängigkeit der Amplituden und Phasen der Übertragungsfunktionen von der Ordnung der Harmonischen (d.h., dem Vielfachen der Rotationsfrequenz, bei dem die Übertragungsfunktion bestimmt wurde), erlauben, die dann im Vergleich überprüft werden.

Die Messgrösse kann insbesondere eine Wellenspannung sein. In diesem Falle wird bevorzugt als Hilfsgrösse eine Änderung der Wellenspannung gegenüber einem Referenzwert bestimmt. Es wird dann vorzugsweise für mehrere Vielfache der Rotationsfrequenz eine Übertragungsfunktion zwischen einem spektralen Anteil des magnetischen Statorflusses und einem spektralen Anteil der Hilfsgrösse beim gleichen Vielfachen der Rotationsfrequenz berechnet. Sodann wird bestimmt, inwieweit mindestens eine der folgenden Eigenschaften erfüllt ist:

- Die Amplitude der Übertragungsfunktion hängt quadratisch von dem Vielfachen der Rotationsfrequenz ab, bei dem der spektrale Anteil bestimmt wurde;
- Die Phase der Übertragungsfunktion hängt linear von dem Vielfachen der Rotationsfrequenz ab.

Diese erwarteten Eigenschaften können aus einem theoretischen Modell hergeleitet werden, wie dies im Folgenden noch beschrieben wird.

Alternativ kann die Messgrösse z. B. ein Ringfluss entlang einer geschlossenen Bahn um die Welle sein, der z.B. direkt durch Messung mit geeigneten Sonden oder indirekt aus Induktionsspannungen in geeigneten Leiterschleifen bestimmt wurde. Als Hilfsgrösse wird dann vorzugsweise eine Änderung des Ringflusses gegenüber einem Referenzwert herangezogen. Wiederum wird für mehrere Vielfache der Rotationsfrequenz eine Übertragungsfunktion zwischen einem spektralen Anteil des magnetischen Statorflusses und einem spektralen Anteil der Hilfsgrösse beim gleichen Vielfachen der Rotationsfrequenz berechnet. Es wird nun bestimmt, inwieweit mindestens eine der folgenden Eigenschaften erfüllt ist:

- Die Amplitude der Übertragungsfunktion hängt linear von dem Vielfachen der Rotationsfrequenz ab;
- Die Phase der Übertragungsfunktion hängt linear von dem Vielfachen der Rotationsfrequenz ab.

Auch diese Eigenschaften lassen sich aus einem theoretischen Modell herleiten, das im Folgenden noch beschrieben wird.

In diesen Beispielen wurde als Hilfsgrösse jeweils eine Änderung der Messgrösse gegenüber einem Referenzwert herangezogen. Dies ist auch ganz allgemein von Vorteil, auch wenn andere Messgrössen als die Wellenspannung oder der Ringfluss bestimmt werden. Die Messgrösse hängt dabei meist nicht nur davon ab, ob ein Interlaminarkurzschluss vorliegt, sondern sie ist auch mehr oder weniger ausgeprägt vom Lastzustand der elektrischen Maschine abhängig. Daher werden vorteilhaft zu einem Referenzzeitpunkt für ausgewählte Referenz-Lastzustände der elektrischen Maschine Referenzwerte der Messgrösse ermittelt und in einem Speicher abgelegt. Zur Ermittlung der Hilfsgrösse wird dann mindestens ein Referenzwert der Messgrösse bei einem Referenz-Lastzustand herangezogen der einem momentanen Lastzustand ähnlich ist.

Der magnetische Statorfluss wird bevorzugt während der Durchführung des Verfahrens ermittelt, z. B. durch eine geeignete Messung. Es ist aber auch möglich, dass zu einem Referenzzeitpunkt für ausgewählte Referenz-Lastzustände der elektrischen Maschine Referenzwerte des magnetischen Statorflusses ermittelt und in einem Speicher abgelegt werden. Für den Vergleich mit dem theoretischen Modell wird dann mindestens ein Referenzwert des magnetischen Statorflusses bei einem Referenz-Lastzustand herangezogen, der dem momentanen Lastzustand ähnlich ist, um den Einfluss des Lastzustands auf das Ergebnis des Vergleichs zu minimieren.

Der magnetische Statorfluss kann in beiden Fällen durch mindestens eine magnetische Messsonde ermittelt werden, die vorteilhaft in einem zwischen Stator und Rotor angeordneten Luftspalt der elektrischen Maschine oder im Stator der elektrischen Maschine angeordnet ist. Stattdessen oder zusätzlich kann der magnetische Statorfluss aber auch rechnerisch aus einer Klemmenspannung der elektrischen Maschine und/oder aus Maschinenparametern und Lastparametern der elektrischen Maschine bestimmt werden.

Eine erfindungsgemässe Vorrichtung zur Ermittlung von interlaminaren Kurzschlüssen weist dementsprechend bevorzugt auf:

- eine Messanordnung zur Ermittlung einer Messgrösse, die auf einen durch den magnetischen Statorfluss hervorgerufenen Kurzschlussstrom zwischen mindestens zwei Statorblechen empfindlich ist;
- eine Einheit zur Ermittlung des magnetischen Statorflusses aus gemessenen Daten und/oder durch Berechnung sowie
- eine Auswerteeinheit, welche dazu ausgebildet ist, die Messgrösse oder die Hilfsgrösse mit einem theoretischen Modell für den Zusammenhang zwischen der Messgrösse oder der Hilfsgrösse und dem magnetischen Statorfluss zu vergleichen und aus dem Vergleich mindestens einen Wert zu ermitteln, der ein Mass für das Vorliegen eines Kurzschlusses darstellt.

Die Einheit zur Ermittlung des Statorflusses sowie die Auswerteeinheit können in Hardware, in Software oder in einer Kombination aus Hard- und Software realisiert sein.

In einer bevorzugten Ausgestaltung umfasst die Auswerteeinheit ein in Hardware und/oder Software realisiertes Transformationsmodul, welches dazu ausgebildet ist, spektrale Anteile der Messgrösse oder einer daraus abgeleiteten Hilfsgrösse zu ermitteln, z.B. durch Filterung in der Zeitdomäne und Fouriertransformation. Die Auswerteeinheit ist dann dazu ausgebildet, ausgewählte spektrale Anteile der Messgrösse oder einer daraus abgeleiteten Hilfsgrösse mit dem theoretischen Modell zu vergleichen.

Wenn die Messgrösse die Wellenspannung ist, umfasst die Messanordnung vorzugsweise mindestens zwei Bürsten (Kontakte), um die Wellenspannung zwischen zwei unterschiedlichen axialen Orten auf der Welle zu ermitteln.

Wenn die Messgrösse ein Ringfluss entlang einer geschlossenen Bahn um die Welle ist, umfasst die Messanordnung vorzugsweise mindestens eine magnetische Messsonde, z. B. zwei oder mehr in verschiedenen radialen Ebenen angeordnete Messschleifen, zur Bestimmung des Ringflusses.

Bevorzugt umfasst die Einheit zur Ermittlung des magnetischen Statorflusses mindestens eine magnetische Messsonde zur Messung des Statorflusses. Stattdessen kann diese Einheit aber auch ein in Hardware und/oder Software realisiertes Modul umfassen, um den Statorfluss zu berechnen, z.B. aus Konstruktions- und Leistungsdaten oder aus der Klemmenspannung.

## Kurze Beschreibung der Zeichnungen

Bevorzugte Ausführungsformen der Erfindung werden im Folgenden anhand der Zeichnungen beschrieben, in denen zeigen:

Fig. 1    eine schematische Darstellung verschiedener Grössen in einer Ebene senkrecht zur Wellenachse;
Fig. 2    eine Prinzipskizze zur Entstehung des Kurzschlussstroms; sowie
Fig. 3    eine schematische Vektordarstellung verschiedener Grössen; sowie
Fig. 4    ein Ausführungsbeispiel einer erfindungsgemässen Vorrichtung.

## Wege zur Ausführung der Erfindung

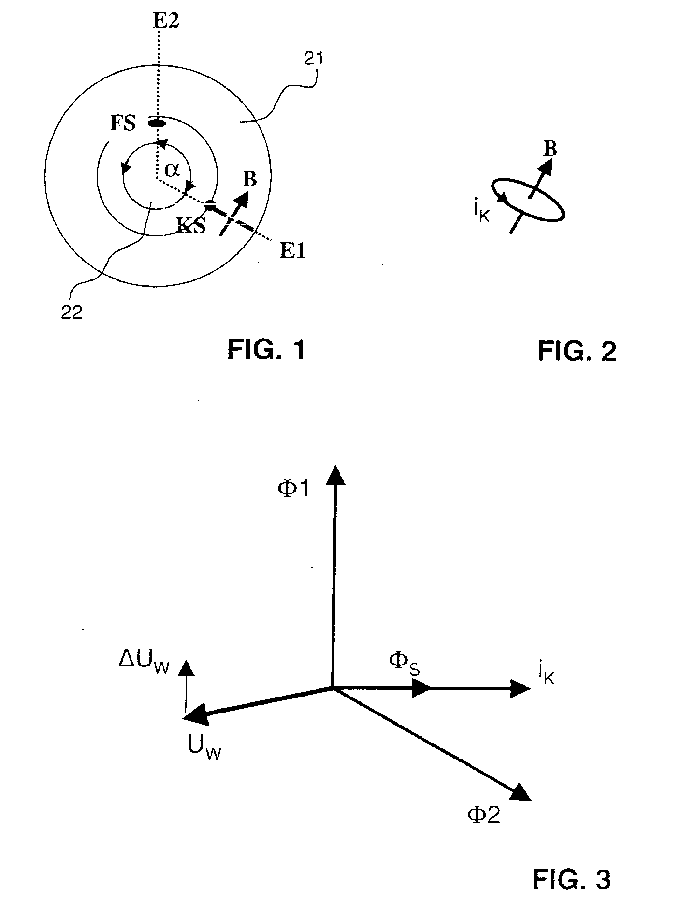

Im Folgenden sollen zunächst die physikalischen Prinzipien erläutert werden, die dem erfindungsgemässen Verfahren zugrunde liegen, und hieraus soll ein theoretisches Modell für verschiedene Messgrössen hergeleitet werden. Hierzu wird zunächst auf die Figuren 1 bis 3 Bezug genommen.

Allgemein werden in diesem Verfahren interlaminare Kurzschlüsse detektiert, indem Änderungsmuster der Wellenspannung, oder, allgemeiner, der Ringflüsse im Stator, untersucht werden. Bevorzugt wird nach charakteristischen Änderungsmustern im Spektrum der Wellenspannung oder der Ringflüsse gesucht, die einen Interlaminarkurzschluss eindeutiger identifizieren.

Das erfindungsgemässe Verfahren beruht auf einer Reihe von Grundlagen. Eine erste wichtige Grundlage besteht in der Erkenntnis, dass bis zu einer gewissen Grenzfrequenz (in der Regel bis ca. 1000 Hz) der elektrische Kreis des Blechkurzschlusses stark resistiv wirkt. Erst bei höheren Frequenzen wechselt die Impedanz des Kreises in den induktiven Bereich. Diese Eigenschaft gilt insbesondere für Kreise mit Blechschlüssen, die an der Oberfläche des Blechpakets liegen. Nach dem Induktionsgesetz ist die im Blechschlusskreis induzierte Spannung der ersten zeitlichen Ableitung des magnetischen Statorflusses $\Phi$, der diesen Kreis durchtritt, direkt proportional. Wegen der resistiven Eigenschaften des Blechkurzschlusses gilt diese Proportionalität bei niedrigen Frequenzen auch für den Wirbelstrom oder Kurzschlussstrom $i_K$:

$$i_K \propto \frac{d\Phi}{dt}, \qquad (1)$$

wobei die Proportionalitätskonstante von den Eigenschaften des Blechschlusskreises abhängt.

Dieser Sachverhalt gilt ebenso für die einzelnen Harmonischen des Stromes, d.h., für jede spektralen Anteil des Kurzschlussstroms bei einem Vielfachen n der Rotationsfrequenz $f_r$. Für jede einzelne Harmonische kann eine Transferfunktion oder Stromübertragungsfunktion gebildet werden, die den Zusammenhang zwischen der betreffenden Harmonischen des Kurzschlussstroms im Blechschlusskreis als Ausgangsgrösse und der entsprechenden Harmonischen des Statorflusses als Eingangsgrösse beschreibt. Der Absolutbetrag dieser Übertragungsfunktion steigt (bei konstanter Rotationsfrequenz) mit der Ordnung n der Harmonischen jeweils annähernd linear:

$$\left| \frac{i_{k,n}}{\Phi_n} \right| \propto n. \qquad (2)$$

Die Phasenverschiebungen der Harmonischen des elektrischen Stromes in Relation zu den Harmonischen des magnetischen Statorflusses betragen dabei jeweils annähernd -90° (bei rechtswendiger Zuordnung von Induktionsvektor und Stromrichtung), unabhängig von Rotationsfrequenz und Ordnung:

$$\arg\left( \frac{i_{k,n}}{\Phi_n} \right) = -\frac{\pi}{2}. \qquad (3)$$

Die Stromharmonischen laufen den Flussharmonischen also um 90° nach.

In den Figuren 1 und 2 sind die Zusammenhänge zwischen veränderlichem Magnetfeld B und Kurzschlussstrom $i_K$ illustriert. In der Fig. 1 sind dazu schematisch ein äusserer Stator 21 und ein darin in Pfeilrichtung (gegen den Uhrzeigersinn) rotierender Rotor 22 dargestellt. An der Innenseite des Stators 21 befindet sich ein Kurzschluss KS. Der Kurzschluss kann als geschlossene Leiterschleife betrachtet werden, in der ein Kurzschlussstrom $i_K$ in einer radialen Ebene E1 fliesst. Wie in der Fig. 2 illustriert wird, fliesst der Kurzschlussstrom orthogonal zum (zeitlich veränderlichen) Statorfluss, der hier durch das Magnetfeld B dargestellt ist.

Eine weitere Grundlage ist die Erkenntnis, dass ein Teil des vom Kurzschlussstrom bewirkten, zusätzlichen magnetischen Flusses als Ringfluss durch den Stator fliesst und den Rotor bzw. die Welle der Maschine umschliesst. Der zusätzliche Ringfluss ist direkt proportional zum Kurzschlussstrom:

$$\Phi_S \propto i_K. \qquad (4)$$

Der Ringfluss ist in der Fig. 3 in einer Zeigerdarstellung illustriert. Ringfluss $\Phi_S$ und Kurzschlussstrom $i_K$ sind phasengleich und stehen in einer festen Phasenbeziehung zu den Stator-Hauptflüssen $\Phi1$, $\Phi2$. Der zeitlich veränderliche Ringfluss $\Phi_S$ induziert wiederum eine Spannung in axialer Richtung der Welle des Rotors, d.h., er führt zu einer Zusatzkomponente $\Delta U_W$ der Wellenspannung $U_W$, die in ihrer Phase orthogonal zum Ringfluss $\Phi_S$ ist.

Der zusätzliche Ringfluss kann somit beispielsweise direkt durch Ringfluss-Messsensoren oder vorzugsweise indirekt durch Messung der Wellenspannung ermittelt werden. Ringfluss-Messsensoren sind z. B. zwei oder mehr dimensionsgleiche Leiterschleifen, die im Stator an gleicher axialer Position, jedoch an in Umfangsrichtung um gewisse Winkel, z. B. um 180°, versetzten Stellen angeordnet sind.

Die Wellenspannung kann in bekannter Weise durch Spannungsmessung über Schleifkontakte (Bürsten) ermittelt werden. Der mit dem Kurzschlussstrom einhergehende Ringfluss induziert in der Schleife zwischen Welle, Gehäuse/Erde und Messgerät eine zusätzliche, charakteristische Komponente der Wellenspannung, die ohne Blechschlussstrom nicht vorhanden wäre. Im Folgenden wird nur die Wellenspannung erörtert, doch gelten die Feststellungen sinngemäss genauso für jede andere Spannung, die zur zeitlichen Ableitung des Ringflusses proportional ist, z.B. für die Spannung, die mit Ringfluss-Messsensoren ermittelt werden kann.

Die zusätzliche, auf den Blechschluss zurückzuführende Komponente der Wellenspannung hat die folgenden Eigenschaften, die das theoretische Modell für die zusätzliche Komponente bilden:

- Es sind alle Harmonischen vorhanden, die auch der Statorfluss aufweist. Dies ist ein wesentlicher Unterschied zur normalen Wellenspannung, die je nach Konstruktion der Maschine nur einige wenige Harmonische des Statorflusses in dominanter Grösse aufweist.
- Die zusätzliche Komponente der Wellenspannung ist proportional zur ersten zeitlichen Ableitung des zusätzlichen Ringflusses $\Phi_S$, also proportional zur zweiten zeitlichen Ableitung des Statorflusses:

$$U_w \propto \frac{d\Phi_S}{dt} \propto \frac{di_k}{dt} \propto \frac{d^2\Phi}{dt^2} \; . \qquad (5)$$

Das Verhältnis zwischen den Amplituden der Harmonischen dieser Komponente und den Amplituden der entsprechenden Harmonischen des Statorflusses steigt im resistiven Bereich der Kurzschlussschleife aufgrund der zweiten zeitlichen Ableitung in dieser Gleichung quadratisch mit der Ordnung der Harmonischen:

$$\left| \frac{U_{w,n}}{\Phi_n} \right| \propto n^2 \qquad (6)$$

- Die Phasenverschiebungen zwischen einander entsprechenden Harmonischen der Zusatzkomponente und des Statorflusses sind durch die Impedanz der Kurzschlussschleife bzw. deren Stromübertragungsfunktion bestimmt. Im unteren, resistiven Frequenzbereich wird diese Phasenverschiebung annähernd verschwinden, wenn als Phasenreferenz der magnetische Fluss betrachtet wird, der durch die Ebene des Interlaminarkurzschlusses fliesst. In diesem resistiven Bereich weicht das Phasenspektrum der Zusatzkomponente der Wellenspannung nur geringfügig vom Phasenspektrum des Statorflusses ab. Wenn andere Durchtrittsebenenen des Flusses als Referenzebene zur Phasenwinkelberechnung betrachtet werden, muss die Phasenverschiebung zwischen der Ebene des Blechschlusses und der Referenzebene durch geeignete Addition von Phasenwinkeln berücksichtigt werden, wobei die Drehrichtung zu berücksichtigen ist. Positive Zusatzwinkel ergeben sich, wenn die Blechschlussebene in Drehrichtung vor der Referenzebene liegt. Dies ist in der Fig. 1 illustriert, in der eine Messsonde (Feldsonde) FS zur Messung des Statorflusses in einer Referenzebene E2 angebracht ist. Die einzelnen Zusatzphasenwinkel $\varphi(n)$ der Harmonischen ergeben sich aus den Ordnungszahlen n der Harmonischen, der Polpaarzahl p und dem Winkel $\alpha$ zwischen den zwei Ebenen zu

$$\varphi(n) = n \cdot p \cdot \alpha \qquad (7)$$

- Es kann somit eine (diskrete) Transferfunktion $T(jn)$ gefunden werden, welche die Relation zwischen den Harmonischen mit Ordnung n der Änderungskomponente der Wellenspannung und den Harmonischen des Statorflusses beschreibt, und die folgende Bedingungen zumindest im tieferen Frequenzbereich erfüllt:

$$T(jn) = A(n) \cdot e^{j\varphi(n)} \; \text{mit} \; A(n) = C \cdot n^2, \; \varphi(n) = n \cdot p \cdot \alpha, \qquad (8)$$

und somit

$$T(jn) = C \cdot n^2 \cdot e^{j(np\alpha)} \; . \qquad (9)$$

- In die Konstante C (sie ist bei tieferen Frequenzen relativ unabhängig von der Ordnung n) geht die "Grösse" des

6

Blechkurzschlusses ein, sie ist proportional dem Produkt der Länge der Fehlerstelle (genaugenommen proportional zur Fläche der Schleife) mit der Stromstärke. Da in der Kurzschlussschleife eine Spannung induziert wird, die der Länge der Fehlerstelle proportional ist, kann C auch als ein Mass für die Kurzschlussleistung interpretiert werden. Aus dem Phasenverschiebungswinkeln $n \cdot p \cdot$ a kann der Ort des Kurzschlusses ermittelt werden.

Eine weitere Grundlage der vorliegenden Erfindung besteht in der Erkenntnis, dass zudem eine (diskrete) Transferfunktion bzw. Übertragungsfunktion $W(jn)$ der gesamten Wellenspannung, einschliesslich der Anteile, die nicht vom zusätzlichen Ringfluss herrühren, gebildet werden kann, die den Zusammenhang zwischen Wellenspannung und Statorfluss im Frequenzbereich beschreibt, und dass diese Transferfunktion in relativ weiter Umgebung eines Lastpunktes der Maschine von der jeweiligen, momentanen Last relativ unabhängig ist.

Diese Charakteristika der gesamten Wellenspannung und der Zusatzkomponente erlauben nun die folgende Vorgangsweise, um einen Interlaminarkurzschluss aus einem Vergleich mit historischen Daten zu detektieren:

A. Es wird ein Vergleich des Spektrums der aktuellen Wellenspannung mit dem Spektrum einer Referenz-Wellenspannung vorgenommen, die bei annähernd gleichen Lastverhältnissen und ohne Vorliegen eines Blechfehlers aufgenommen wurde. Bei Vorliegen eines Blechschlusses werden sich die Phasenwinkel der Harmonischen der Wellenspannung ändern, und es werden zusätzliche Harmonische auftreten. Durch vektorielle Subtraktion von einander entsprechenden Harmonischen (d.h. der Harmonischen mit gleichen Ordnungsnummern) kann das Spektrum einer Änderungskomponente der Wellenspannung ermittelt werden. Falls dieses Spektrum die oben genannten Phasen- und Amplitudenbedingungen des theoretischen Modells erfüllt, deutet dies auf einen Interlaminarkurzschluss hin. Das Spektrum wird also vorzugsweise auf eine oder mehrere der folgenden Bedingungen hin untersucht:

- Das Phasenspektrum der Änderungskomponente der Wellenspannung ergibt sich aus dem Spektrum des Flusses durch Addition von Phasenwinkeln $\varphi(n) = n \cdot p \cdot \alpha$. Die Phasenverschiebungen zwischen einander entsprechenden Harmonischen des Flusses und der Änderungskomponente weisen also im unteren Frequenzbereich, d.h. im resistiven Bereich der Kurzschlussschleife, den konstanten Term $\alpha$ auf. Im höheren Frequenzbereich ändert sich die Phasenverschiebung entsprechend der Stromübertragungsfunktion der Kurzschlussschleife.
- Das Amplitudenspektrum der Änderungskomponente ergibt sich bei tieferen Frequenzen annähernd aus dem Amplitudenspektrum des Flusses durch Multiplikation mit einem Faktor, der quadratisch mit der Frequenz steigt,

$$k = C \cdot n^2 \, ,$$

wobei C eine Konstante über alle Ordnungen n ist.
- Es treten im Spektrum der Änderungskomponente Linien verstärkt in Erscheinung, die im Spektrum der Wellenspannung nicht oder nur schwach vorhanden sind.
- Es kann eine (diskrete) Transferfunktion gefunden werden, die die Relation zwischen den Harmonischen der Änderungskomponente und den Harmonischen des Statorflusses beschreibt, und die folgende Bedingungen zumindest im tieferen Frequenzbereich erfüllt:

$$T(jn) = A(n) \cdot e^{j\varphi(n)} \text{ mit } A(n) = C \cdot n^2 \, , \ \varphi(n) = n \cdot p \cdot \alpha \, .$$

Auf das Vorliegen einer oder mehrerer dieser Bedingungen kann z.B. aus den Ergebnissen eines nichtlinearen Fits geschlossen werden, der für die einzelnen Harmonischen des Spektrums der Änderungskomponente auf Grundlage der genannten Gleichungen durchgeführt wird und aus dem mindestens eine der folgenden Grössen bestimmt wird: der Wert der Konstanten C, der Wert des Winkels $\alpha$ sowie ein oder mehrere statistische Parameter, die die Qualität des Fits beschreiben und dadurch Rückschlüsse auf die Wahrscheinlichkeit eines Interlaminarkurzschlusses ermöglichen.

B. Vorteilhafterweise werden hierbei die momentanen Harmonischen des magnetischen Statorflusses durch Messung ermittelt und in Relation zu den entsprechenden Harmonischen dieser Änderungskomponente der Wellenspannung gesetzt.

C. Eine simultane Messung der Harmonischen des Statorflusses und der Harmonischen der Wellenspannung erlaubt es, eine Transferfunktion bzw. Übertragungsfunktion $W(jn)$ der Wellenspannung zu ermitteln, die die Relation zwischen Wellehspannung und Statorfluss im Frequenzbereich beschreibt. Diese Transferfunktion ist mit guter Näherung auch in der Umgebung eines Lastpunktes gültig, da sich die Eigenschaften des magnetischen Pfades in der Umgebung eines Lastpunktes nur wenig ändern. Somit brauchen zur Referenzbildung bei bekannt blechschlussfreier Maschine nur einige wenige Referenz-Lastpunkte angefahren zu werden und die Transferfunktionen der Wellenspannung in diesen Lastpunkten als Referenz-Transferfunktionen $W_{Ref}(jn)$ ermittelt und abgespeichert werden. Ein Interlaminarkurzschluss wird diese Transferfunktionen in der oben beschriebenen Weise ändern:

$$W(jn) = W_{Ref}(jn) + T(jn) \qquad (10)$$

Somit können Änderungen der Transferfunktion, die die genannten Kriterien erfüllen, als Hinweis auf einen Interlaminarkurzschluss gewertet werden.

D. Zur Ermittlung der Harmonischen des Statorflusses werden vorteilhafterweise die sogenannten Streufeld-Messpulen ("strayflux coils") verwendet, die im Luftspalt vieler Generatoren ohnehin eingebaut sind, um Windungsschlüsse des Rotors zu detektieren. Die Messspule für das Radialfeld (Feldkomponenten in senkrechter Richtung zur Rotoroberfläche), wird z. B. direkt vom Hauptfluss durchflossen. Durch Spannungsmessung können Werte gemessen werden, die proportional zu den ersten zeitlichen Ableitungen der Harmonischen des Statorflusses sind. Durch zeitliche Integration ergeben sich daraus Werte, die proportional zu den Harmonischen des Statorflusses sind. Je nach Lage dieser Messspulen ergibt sich noch eine zusätzliche Phasenverschiebung zwischen den Vektoren der Harmonischen des Statorflusses und den entsprechenden Vektoren der Änderungskomponente. Dies erlaubt auch eine Lokalisierung des Blechschlusses anhand des zusätzlichen Phasenwinkels.

E. Zur direkten Ermittlung der Harmonischen des Statorflusses kann weiterhin im Stator eine Leiterschleife angeordnet werden, die durch die Kühlschlitze verläuft und von einem Teil des Statorflusses durchflossen wird. Durch Spannungsmessung können die ersten zeitlichen Ableitungen der Harmonischen des Statorflusses ermittelt werden. Je nach Lage dieser Hilfsschleife und damit der Referenzebene ergibt sich wieder eine zusätzliche Phasenverschiebung zwischen den Vektoren der Harmonischen des Statorflusses und den entsprechenden Vektoren der Änderungskomponente. Dies erlaubt wiederum eine Lokalisierung des Blechschlusses anhand des zusätzlichen Phasenwinkels.

F. Bei Verwendung von Ringflusssensoren können die Einzelspulen natürlich auch zur Ermittlung der Harmonischen des Flusses verwendet werden. Die Verwendung mehrerer Referenzebenen erlaubt dabei noch eine zuverlässigere Ermittlung der Schadensebene.

G. Falls geeignete Spannungsteiler (d.h. mit geeignetem, zumindest bekanntem Frequenzgang) vorhanden sind, können Aussagen über das Spektrum des Statorflusses auch direkt aus den Klemmenspannungen des Generators gewonnen werden.

H. Vorzugsweise werden als historische Referenzinformationen die Spektren der Wellenspannung zusammen mit den simultan gemessenen Spektren der Streufeldspulen bzw. den Spektren des Statorflusses bei einer Vielzahl von Lastpunkten z.B. beim Anfahren der Maschine aufgenommen (bevorzugt im Bereich des Normalbetriebspunktes), zusammen mit den Daten über den Lastpunkt (Wirkleistung, Blindleistung). Dies erlaubt eine noch genauere Ermittlung einer Änderungskomponente, da eine Vielzahl von Referenz - Transferfunktionen oder Referenzspektren vorhanden ist.

J. Falls nur beschränkte Mengen an Referenzwerten bzw. historischen Informationen über die Wellenspannung bei verschiedenen Lastzuständen vorhanden sind, können nicht alle, sondern nur neu auftretende Harmonische der Wellenspannung zur Analyse verwendet werden. Der spektrale Gehalt der Wellenspannung ist ja unabhängig vom Lastzustand in dem Sinne, dass aufgrund der Maschinengeometrie unterdrückte Spektrallinien auch bei unterschiedlichen Lastzuständen nicht auftreten. Somit können neu auftretende Harmonische bevorzugt als Teile der oben genannten Änderungskomponente gewertet werden.

K. Falls die Harmonischen des Statorflusses einer direkten Messung nicht zugänglich sind, können die Harmonischen näherungsweise auch aus den Konstruktionsdaten der Maschine berechnet werden.

L. Die Anordnung der oben genannten elektrischen Hilfsschleife, die Teile des Statorblechpaketes umschliesst, erlaubt es auch, gezielt einen Referenz-Blechschlusskreis mit bekannter Geometrie (Stromstärke, Impedanz) in die Maschine einzubringen. Durch aktive, zeiliche Variation der Eigenschaften des Kreises, z. B. der Stromstärke (Öffnen und Schliessen des Blechschlusskreises), und entsprechender Messung der Parameter (Stromstärke bei geschlossenem Kreis, Spannung bei offenem Kreis) kann ermittelt werden, wie sich ein Interlaminarkurzschluss bekannter Grösse auf die Wellenspannung auswirkt. Dies erlaubt es, die Stärke und somit das Gefährdungspotential eines tatsächlich vorhandenen Blechkurzschlusses durch Vergleich mit einem Referenzwert zu beurteilen. Durch aktive Betriebsmittel wie z. B. elektronische Stromquellen können auch Prüfströme mit bekannter Frequenz, Amplitude und Phasenlage eingeprägt werden und deren Auswirkungen auf die Wellenspannung als Referenzwerte abgespeichert werden. Es kann so die Transferfunktion der Änderungskomponente eines bekannten Blechschlusskreises ermittelt werden.

Die selben Aussagen gelten, wenn statt der Wellenspannung eine induzierte Spannung gemessen wird, die durch den Ringfluss hervorgerufen wird, z. B. in Ringfluss-Messsonden. Wenn stattdessen unmittelbar der Ringfluss gemessen wird, können entsprechend analoge Aussagen getroffen werden. Der Ringfluss ist der ersten zeitlichen Ableitung des Statorflusses proportional, was sich direkt aus Gleichungen (1) und (4) ergibt. Damit steigt die Amplitude der Übertragungsfunktion für die Änderungskomponente des Ringflusses nicht quadratisch (wie bei der Wellenspannung), sondern linear mit der Ordnung n der Harmonischen an. Für die Phasen bleibt eine lineare Abhängigkeit bestehen.

Beispiel:

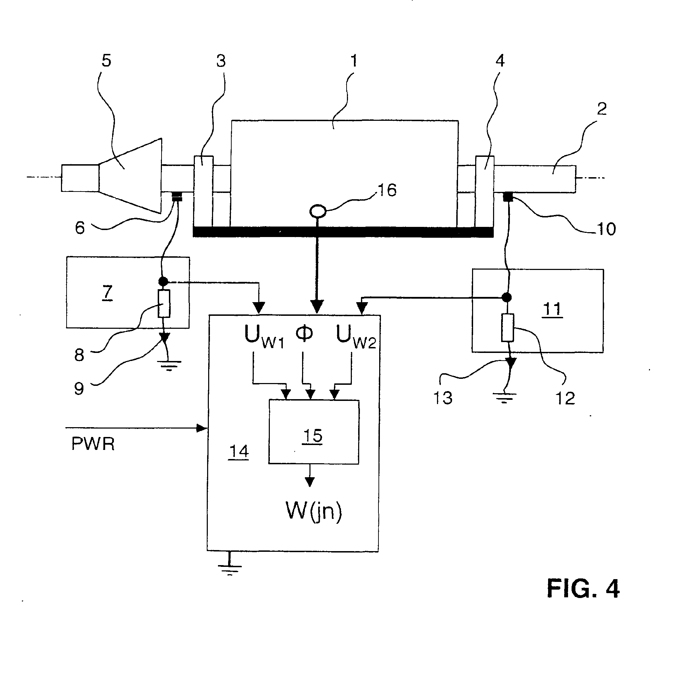

Dieses Konzept soll nun anhand eines konkreten Beispiels näher erläutert werden. In Fig. 4 ist eine bevorzugte Messanordnung dargestellt. Ein Generator 1 weist eine Welle 2 auf, die in Lagern 3, 4 gelagert ist und von einer Turbine 5 angetrieben wird. Die Welle 2 ist über zwei Erdungsbürsten 6, 10 und zwei Erdungsmodule 7, 11 geerdet. Dabei fallen über den Erdungswiderständen 8, 12 zwei unterschiedliche Wellenspannungen $U_{W1}$, $U_{W2}$ ab. Das DE-Erdungsmodul 7 (DE = Drive End, Antriebsseite) ist niederohmig, das RC-Modul 11 (RC = Resistor/Capacitor, Widerstand/Kapazität) ist höherohmig, so dass die durch den Erdungsstrom 13 abgegriffene Wellenspannung $U_{W2}$ am RC-Modul höher sein wird als die durch den Erdungsstrom 9 abgegriffene Wellenspannung $U_{W1}$ am DE-Modul. Beide Wellenspannungen werden der Auswerteeinheit 14 zugeführt. Des weiteren ist am Stator des Generators 1 eine Messspule 16 angeordnet, deren Ausgangsspannung ebenfalls der Auswerteeinheit 14 zugeführt wird. Diese Spule ist im Luftspalt des Generators angeordnet und misst den Hauptfluss $\Phi$. Zusätzlich werden der Auswerteeinheit 14 verschiedene Daten PWR über den Lastzustände des Generators, z.B. die Wirkleistung in MW und die Blindleistung in WVAr zugeführt.

Die Eingangsspannungen der Auswerteeinheit werden mittels ADCs digitalisiert. Die Auswerteeinheit 14 misst nun kontinuierlich die Wellenspannung und das Hauptflusssignal und berechnet mittels geeigneter Filterung und FFT (Fast Fourier Transform, schnelle Fouriertransformation) die Phasen- und Amplitudenspektren dieser Grössen. Hierzu ist in der Auswerteeinheit 14 ein Transformationsmodul 15 vorhanden, das in Hardware oder Software implementiert sein kann. Aus den Spektren bzw. dessen Werten bei ganzzahligen Vielfachen der Rotationsfrequenz berechnet die Auswerteeinheit kontinuierlich die diskreten Übertragungsfunktionen $W(jn)$ und vergleicht kontinuierlich diese Übertragungsfunktionen mit Referenzwerten $W_{Ref}(jn)$, die in gleichen oder ähnlichen Lastzuständen aufgenommen wurden. Diese Referenzwerte wurden z.B. bei Inbetriebnahme des Generators bei verschiedenen Belastungszuständen oder sogar im gesamten Lastbereich aufgenommen und in der Auswerteeinheit abgespeichert.

Durch Subtraktion der Referenzwerte bzw. Referenzspektren wird eine Änderungskomponente $T(jn)$ gewonnen.

Diese Änderungskomponente wird aufgezeichnet, und das theoretische Modell wird periodisch (in kleinen zeitlichen Abständen, z.B. einige Male pro Minute) an die Änderungskomponente angefittet, z.B. durch einen nichtlinearen Fit der Gleichung (8) an die Amplituden und Phasen der Änderungskomponente, wobei in diesem Fall die Konstanten $C$ und $\alpha$ als Fitparameter dienen. Aus dem Fit werden die Konstanten $C$ und $\alpha$ sowie statistische Parameter des Fits gewonnen und abgespeichert. Diese Grössen werden mit vorbestimmten Bedingungen verglichen. Falls eine dieser Bedingungen erfüllt ist, wird auf das Vorliegen eines Blechschlusses geschlossen, und es wird ein Alarmsignal ausgegeben. Eine geeignete Bedingung ist z.B., dass ein statistischer Test, z.B. ein Chi-Quadrat-Test, mit einer gewissen Signifikanz die Hypothese stützt, dass die gemessenen Änderungskomponenten dem theoretischen Modell genügen. Aus den ermittelten Werten von C und $\alpha$ kann nun auf die Grösse und den Ort des Blechschlusses geschlossen werden. Zudem können aus den aufgezeichneten Daten Erkenntnisse über die Entwicklung des Blechschlusses gewonnen werden.

Zusammenfassend kann das Verfahren und die Vorrichtung der vorliegenden Erfindung die Eigenschaft aufweisen,

- dass zur Feststellung eines Blechschlusses ein charakteristisches Muster der Änderung der Wellenspannung der Maschine in Relation zu einer Referenz-Wellenspannung gesucht wird, wobei dieses Änderungsmuster aus Referenzwerten des magnetischen Statorflusses gewonnen wird;

- dass diese Referenzwerte des Statorflusses spektrale Kennwerte des Statorflusses sind;
- dass zur Gewinnung der spektralen Kennwerte des Statorflusses die Messwerte von Streufeldspulen, die im Luftspalt der Maschine angeordnet sind, oder Messschleifen, die direkt in das Statorblechpaket eingefügt sind, verwendet werden;
- oder dass diese spektralen Kennwerte aus Messungen der Klemmenspannung abgeleitet werden;
- oder dass diese spektralen Kennwerte rechnerisch aus Maschinenparametem und Lastparametern abgeleitet werden;
- dass momentan gemessene Referenzwerte des Statorflusses verwendet werden;
- dass historische Referenzwerte des Statorflusses verwendet werden;
- dass Transferfunktionen der Wellenspannung berechnet werden, die den Zusammenhang zwischen dem Spektrum des Statorflusses und dem Spektrum der zugehörigen Wellenspannung beschreiben, und dass das Änderungsmuster als Änderungsmuster in den Transferfunktionen gesucht wird, wozu die momentane Transferfunktion mit einer historischen Transferfunktion verglichen wird;
- dass statt der Wellenspannung eine Spannung zur Analyse verwendet wird, die mittels Ringflusssensoren gemessen wird und die dem Ringfluss im Stator proportional ist;
- dass die benutzte Vorrichtung eine Vorrichtung zur Messung der Wellenspannung und eine Vorrichtung zur Messung des Statorflusses beinhaltet; und/oder
- dass die benutzte Vorrichtung Ringflusssensoren zur Messung des Ringflusses im Stator beinhaltet.

Selbstverständlich ist die Erfindung nicht auf das vorstehende Ausführungsbeispiel beschränkt, sondern es sind zahlreiche Varianten möglich.

**Bezugszeichenliste**

| | |
|---|---|
| 1 | Generator |
| 2 | Welle |
| 3 | erstes Lager |
| 4 | zweites Lager |
| 5 | Turbine |
| 6 | erste Erdungsbürste |
| 7 | DE-Modul |
| 8 | Erdungswiderstand |
| 9 | Erdungsstrom |
| 10 | zweite Erdungsbürste |
| 11 | RC-Modul |
| 12 | Erdungswiderstand |
| 13 | Erdungsstrom |
| 14 | Auswerteeinheit |
| 15 | Transformationseinheit |
| 16 | Messspule |
| 21 | Stator |
| 22 | Rotor |

| | |
|---|---|
| $U_W$ | Wellenspannung |
| $\Delta U_W$ | Änderung der Wellenspannung |
| $U_{W1}$ | erste Wellenspannung |
| $U_{W2}$ | zweite Wellenspannung |
| $\Phi$ | Statorfluss |
| $\Phi 1, \Phi 2$ | Hauptfluss |
| $\Phi_S$ | Ringflusskomponente |
| PWR | Leistungsdaten |
| W(jn) | Übertragungsfunktion |
| E1 | erste Ebene |
| E2 | zweite Ebene |
| B | magnetisches Feld |

KS       Kurzschluss
FS       Feldsonde
$\alpha$       Winkel
$i_K$       Kurzschlussstrom

**Patentansprüche**

1. Verfahren zur Ermittlung von Kurzschlüssen zwischen Statorblechen einer elektrischen Maschine (1), welche einen auf einer Welle (2) rotierenden Rotor (22) und einen Stator (21) aufweist, der von einem zeitlich veränderlichen magnetischen Statorfluss ($\Phi$) durchsetzt wird, wobei im Betrieb der elektrischen Maschine eine Messgrösse ($U_W$;$\Phi_S$) ermittelt wird, die auf einen durch den magnetischen Statorfluss ($\Phi$) hervorgerufenen Kurzschlussstrom ($i_K$) zwischen mindestens zwei Statorblechen empfindlich ist, **dadurch gekennzeichnet, dass** der magnetische Statorfluss ($\Phi$) durch Messung und/oder Berechnung ermittelt wird, dass die Messgrösse ($U_W$;$\Phi_S$) oder eine daraus abgeleitete Hilfsgrösse ($\Delta U_W$) mit einem theoretischen Modell verglichen wird, das einen Zusammenhang zwischen dem magnetischen Statorfluss ($\Phi$) und der Messgrösse ($U_W$;$\Phi_S$) oder der Hilfsgrösse ($\Delta U_W$) herstellt, und dass aus dem Vergleich ein Mass für einen Kurzschluss ermittelt wird.

2. Verfahren nach Anspruch 1, wobei ein Mass für mindestens eine der folgenden Grössen aus dem Vergleich ermittelt wird: Wahrscheinlichkeit des Vorliegens eines Kurzschlusses; Grösse des Kurzschlusses; räumliche Position des Kurzschlusses im Stator.

3. Verfahren nach Anspruch 1 oder 2, wobei der Rotor (22) mit einer Rotationsfrequenz rotiert und spektrale Anteile der Messgrösse ($U_W$;$\Phi_S$) oder der daraus abgeleiteten Hilfsgrösse ($\Delta U_W$) bei Vielfachen der Rotationsfrequenz ermittelt werden und diese spektralen Anteile mit einem theoretischen Modell verglichen werden.

4. Verfahren nach Anspruch 3, wobei für mehrere Vielfache der Rotationsfrequenz eine Übertragungsfunktion zwischen einem spektralen Anteil des magnetischen Statorflusses und einem spektralen Anteil der Messgrösse ($U_W$;$\Phi_S$) oder der daraus abgeleiteten Hilfsgrösse ($\Delta U_W$) beim gleichen Vielfachen der Rotationsfrequenz ermittelt wird und mit einem theoretischen Modell der Übertragungsfunktion verglichen wird.

5. Verfahren nach einem der vorhergehenden Ansprüche, wobei die Messgrösse eine Wellenspannung ($U_W$) ist.

6. Verfahren nach Anspruch 5, wobei als Hilfsgrösse eine Änderung ($\Delta U_W$) der Wellenspannung ($U_W$) gegenüber einem Referenzwert bestimmt wird; wobei für mehrere Vielfache der Rotationsfrequenz eine Übertragungsfunktion zwischen einem spektralen Anteil des magnetischen Statorflusses ($\Phi$) und einem spektralen Anteil der Hilfsgrösse ($\Delta U_W$) beim gleichen Vielfachen der Rotationsfrequenz berechnet wird, und wobei bestimmt wird, inwieweit mindestens eine der folgenden aus einem theoretischen Modell abgeleiteten Eigenschaften erfüllt ist:

     - Die Amplitude der Übertragungsfunktion hängt quadratisch von dem Vielfachen der Rotationsfrequenz ab;
     - Die Phase der Übertragungsfunktion hängt linear von dem Vielfachen der Rotationsfrequenz ab.

7. Verfahren nach einem der Ansprüche 1 bis 4, wobei die Messgrösse ein Ringfluss ($\Phi_S$) entlang einer geschlossenen Bahn um die Welle ist.

8. Verfahren nach Anspruch 7, wobei als Hilfsgrösse eine Änderung des Ringflusses ($\Phi_S$) gegenüber einem Referenzwert herangezogen wird, wobei für mehrere Vielfache der Rotationsfrequenz eine Übertragungsfunktion zwischen einem spektralen Anteil des magnetischen Statorflusses und einem spektralen Anteil der Hilfsgrösse beim gleichen Vielfachen der Rotationsfrequenz berechnet wird, und wobei bestimmt wird, inwieweit mindestens eine der folgenden Eigenschaften als theoretisches Modell erfüllt ist:

     - Die Amplitude der Übertragungsfunktion hängt linear von dem Vielfachen der Rotationsfrequenz ab;
     - Die Phase der Übertragungsfunktion hängt linear von dem Vielfachen der Rotationsfrequenz ab.

9. Verfahren nach einem der vorhergehenden Ansprüche, wobei als Hilfsgrösse eine Änderung der Messgrösse gegenüber einem Referenzwert herangezogen wird.

10. Verfahren nach Anspruch 9, wobei zu einem Referenzzeitpunkt für ausgewählte Referenz-Lastzustände der elektrischen Maschine Referenzwerte der Messgrösse ($U_W$; $\Phi_S$) ermittelt und in einem Speicher abgelegt werden, und wobei zur Ermittlung der Hilfsgrösse mindestens ein Referenzwert der Messgrösse bei einem Referenz-Lastzustand herangezogen wird, der einem momentanen Lastzustand ähnlich ist.

**11.** Verfahren nach einem der vorhergehenden Ansprüche, wobei der magnetische Statorfluss ($\Phi$) während der Durchführung des Verfahrens ermittelt wird.

**12.** Verfahren nach einem der Ansprüche 1 bis 10, wobei zu einem Referenzzeitpunkt für ausgewählte Referenz-Lastzustände der elektrischen Maschine Referenzwerte des magnetischen Statorflusses ($\Phi$) ermittelt und in einem Speicher abgelegt werden, und wobei für den Vergleich mit dem theoretischen Modell mindestens ein Referenzwert des magnetischen Statorflusses ($\Phi$) bei einem Referenz-Lastzustand herangezogen wird, der einem momentanen Lastzustand ähnlich ist.

**13.** Verfahren nach einem der Ansprüche 1 bis 12, wobei der magnetische Statorfluss ($\Phi$) durch mindestens eine magnetische Messsonde (FS) ermittelt wird, die in einem zwischen Stator und Rotor angeordneten Luftspalt der elektrischen Maschine oder im Stator der elektrischen Maschine angeordnet ist.

**14.** Verfahren nach einem der Ansprüche 1 bis 12, wobei der magnetische Statorfluss ($\Phi$) rechnerisch aus einer Klemmenspannung der elektrischen Maschine und/oder aus Maschinenparametern und Lastparametern der elektrischen Maschine bestimmt wird.

**15.** Vorrichtung zur Durchführung eines Verfahrens nach einem der vorhergehenden Ansprüche, welche aufweist:

- eine Messanordnung (6, 7, 10, 11) zur Ermittlung einer Messgrösse, die auf einen durch den magnetischen Statorfluss hervorgerufenen Kurzschlussstrom zwischen mindestens zwei Statorblechen empfindlich ist;
- eine Einheit (12) zur Ermittlung des magnetischen Statorflusses aus gemessenen Daten und/oder durch Berechnung;
- eine Auswerteeinheit (14), welche dazu ausgebildet ist, die Messgrösse oder eine daraus abgeleitete Hilfsgrösse mit einem theoretischen Modell für den Zusammenhang zwischen der Messgrösse oder der Hilfsgrösse und dem magnetischen Statorfluss zu vergleichen, und aus dem Vergleich mindestens einen Wert zu ermitteln, der ein Mass für das Vorliegen eines Kurzschlusses darstellt.

**16.** Vorrichtung nach Anspruch 15, wobei die Auswerteeinheit (14) ein Transformationsmodul (15) umfasst, welches dazu ausgebildet ist, spektrale Anteile der Messgrösse oder einer daraus abgeleiteten Hilfsgrösse zu ermitteln, und wobei die Auswerteeinheit (14) dazu ausgebildet ist, ausgewählte spektrale Anteile der Messgrösse oder einer daraus abgeleiteten Hilfsgrösse mit dem theoretischen Modell zu vergleichen.

**17.** Vorrichtung nach Anspruch 15 oder 16, wobei die Messgrösse eine Wellenspannung ($U_W$) ist und wobei die Messanordnung (6, 7, 10, 11) mindestens zwei Bürsten (6, 10) umfasst, um die Wellenspannung ($U_W$) zwischen zwei unterschiedlichen axialen Orten auf der Welle (2) zu ermitteln.

**18.** Vorrichtung nach Anspruch 15 oder 16, wobei die Messgrösse ein Ringfluss ($\Phi_S$) entlang einer geschlossenen Bahn um die Welle (2) ist und wobei die Messanordnung mindestens eine magnetische Messsonde zur Bestimmung des Ringflusses ($\Phi_S$) umfasst.

**19.** Vorrichtung nach einem der Ansprüche 15 bis 18, wobei die Einheit zur Ermittlung des magnetischen Statorflusses mindestens eine magnetische Messsonde (FS) zur Messung des Statorflusses ($\Phi$) umfasst.

## Claims

**1.** Method for determining short circuits between stator laminates in an electrical machine (1) which has a rotor (22), which rotates on a shaft (2), and a stator (21) through which a magnetic stator flux ($\Phi$), which varies over time, passes, wherein a measurement variable ($U_W$; $\Phi_S$) which is sensitive to a short-circuit current ($i_K$) caused by the magnetic stator flux ($\Phi$) between at least two stator laminates, is determined during operation of the electrical machine, **characterized in that** the magnetic stator flux ($\Phi$) is determined by measurement and/or calculation, **in that** the measurement variable ($U_W$; $\Phi_S$) or an auxiliary variable ($\Delta U_W$) derived therefrom is compared with a theoretical model which produces a relationship between the magnetic stator flux ($\Phi$) and the measurement variable

($U_W$; $\Phi_S$) or the auxiliary variable ($\Delta U_W$), and **in that** a measure for a short circuit is determined from the comparison.

2. Method according to Claim 1, wherein a measure for at least one of the following variables is determined from the comparison: probability of the presence of a short circuit; magnitude of the short circuit; spatial position of the short circuit in the stator.

3. Method according to Claim 1 or 2, wherein the rotor (22) rotates at a rotation frequency and spectral components of the measurement variable ($U_W$; $\Phi_S$) or of the auxiliary variable ($\Delta U_W$) derived therefrom are determined at multiples of the rotation frequency, and these spectral components are compared with a theoretical model.

4. Method according to Claim 3, wherein a transfer function between a spectral component of the magnetic stator flux and a spectral component of the measurement variable ($U_W$; $\Phi_S$) or of the auxiliary variable ($\Delta U_W$) derived therefrom is determined for the same multiple of the rotation frequency for a plurality of multiples of the rotation frequency, and is compared with a theoretical model of the transfer function.

5. Method according to one of the preceding claims, wherein the measurement variable is a shaft voltage ($U_W$).

6. Method according to Claim 5, wherein a change ($\Delta U_W$) in the shaft voltage ($U_W$) with respect to a reference value is determined as the auxiliary variable, wherein a transfer function between a spectral component of the magnetic stator flux ($\Phi$) and a spectral component of the auxiliary variable ($\Delta U_W$) is calculated for the same multiple of the rotation frequency, for a plurality of multiples of the rotation frequency, and wherein a determination is made as to the extent to which at least one of the following characteristics, derived from a theoretical model, is satisfied:

    - the amplitude of the transfer function depends on the square of the multiple of the rotation frequency;
    - the phase of the transfer function depends linearly on the multiple of the rotation frequency.

7. Method according to one of Claims 1 to 4, wherein the measurement variable is a ring flux ($\Phi_S$) along a closed path around the shaft.

8. Method according to Claim 7, wherein a change in the ring flux ($\Phi_S$) with respect to a reference value is used as the auxiliary variable, wherein a transfer function between a spectral component of the magnetic stator flux and a spectral component of the auxiliary variable is calculated for the same multiple of the rotation frequency for a plurality of multiples of the rotation frequency, and wherein a determination is made as to the extent to which at least one of the following characteristics, as theoretical model, is satisfied:

    - the amplitude of the transfer function is linearly dependent on the multiple of the rotation frequency;
    - the phase of the transfer function depends linearly on the multiple of the rotation frequency.

9. Method according to one of the preceding claims, wherein a change in the measurement variable with respect to a reference value is used as the auxiliary variable.

10. Method according to Claim 9, wherein reference values of the measurement variable ($U_W$; $\Phi_S$) are determined at a reference time for selected reference load states of the electrical machine and are stored in a memory, and wherein at least one reference value of the measurement variable in a reference load state, which is similar to an instantaneous load state, is used to determine the auxiliary variable.

11. Method according to one of the preceding claims, wherein the magnetic stator flux ($\Phi$) is determined while the method is being carried out.

12. Method according to one of Claims 1 to 10, wherein reference values of the magnetic stator flux ($\Phi$) are determined at a reference time for selected reference load states of the electrical machine and are stored in a memory, and wherein at least one reference value of the magnetic stator flux ($\Phi$) in a reference load state, which is similar to an instantaneous load state, is used for the comparison with the theoretical model.

13. Method according to one of Claims 1 to 12, wherein the magnetic stator flux ($\Phi$) is determined by at least one magnetic measurement probe (FS), which is arranged in an air gap, which is arranged between the stator and the rotor, of the electrical machine or in the stator of the electrical machine.

**14.** Method according to one of Claims 1 to 12, wherein the magnetic stator flux ($\Phi$) is determined by calculation from a terminal voltage of the electrical machine and/or from machine parameters and load parameters of the electrical machine.

**15.** Device for carrying out a method according to one of the preceding claims, which device has:

- a measurement arrangement (6, 7, 10, 11) for determining a measurement variable which is sensitive to a short-circuit current, caused by the magnetic stator flux, between at least two stator laminates;
- a unit (12) for determining the magnetic stator flux from measured data and/or by calculation;
- an evaluation unit (14), which is designed to compare the measurement variable or an auxiliary variable derived therefrom with a theoretical model for the relationship between the measurement variable or the auxiliary variable and the magnetic stator flux and to determine at least one value from the comparison which represents a measure for the presence of a short circuit.

**16.** Device according to Claim 15, wherein the evaluation unit (14) comprises a transformation module (15) which is designed to determine spectral components of the measurement variable or of an auxiliary variable derived therefrom, and wherein the evaluation unit (14) is designed to compare selected spectral components of the measurement variable or of an auxiliary variable derived therefrom with the theoretical model.

**17.** Device according to Claim 15 or 16, wherein the measurement variable is a shaft voltage ($U_W$) and wherein the measurement arrangement (6, 7, 10, 11) comprises at least two brushes (6, 10) in order to determine the shaft voltage ($U_W$) between two different axial points on the shaft (2).

**18.** Device according to Claim 15 or 16, wherein the measurement variable is a ring flux ($\Phi_S$) along a closed path around the shaft (2), and wherein the measurement arrangement comprises at least one magnetic measurement probe for determining the ring flux ($\Phi_S$).

**19.** Device according to one of Claims 15 to 18, wherein the unit for determining the magnetic stator flux comprises at least one magnetic measurement probe (FS) for measuring the stator flux ($\Phi$).

**Revendications**

**1.** Procédé de détermination de courts-circuits entre une machine électrique (1), laquelle possède un rotor (22) qui tourne sur un arbre (2) et un stator (21) qui est pénétré par un flux de stator magnétique ($\Phi$) variable dans le temps, une grandeur mesurée ($U_W$ ; ($\Phi_S$) étant déterminée lors du fonctionnement de la machine électrique, laquelle est sensible à un courant de court-circuit ($i_K$) provoqué par le flux de stator magnétique ($\Phi$) entre au moins deux tôles de stator, **caractérisé en ce que** le flux de stator magnétique ($\Phi$) est déterminé par mesure et/ou calcul, **en ce que** la grandeur mesurée ($U_W$ ; $\Phi_S$) ou une grandeur auxiliaire ($\Delta U_W$) qui en est dérivée est comparée avec un modèle théorique qui établit une relation entre le flux de stator magnétique ($\Phi$) et la grandeur mesurée ($U_W$ ; $\Phi_S$) ou la grandeur auxiliaire ($\Delta U_W$), et **en ce qu'**une mesure pour un courant de court-circuit est déterminée à partir de la comparaison.

**2.** Procédé selon la revendication 1, selon lequel une mesure pour au moins l'une des grandeurs suivantes est déterminée à partir de la comparaison : probabilité de présence d'un court-circuit ; grandeur du court-circuit ; position spatiale du court-circuit dans le stator.

**3.** Procédé selon la revendication 1 ou 2, selon lequel le rotor (22) tourne à une fréquence de rotation et les composantes spectrales de la grandeur mesurée ($U_W$ ; $\Phi_S$) ou de la grandeur auxiliaire ($\Delta U_W$) qui en est dérivée sont déterminées à des multiples de la fréquence de rotation et ces composantes spectrales sont comparées avec un modèle théorique.

**4.** Procédé selon la revendication 3, selon lequel une fonction de transfert entre une composante spectrale du flux de stator magnétique et une composante spectrale de la grandeur mesurée ($U_W$ ; $\Phi_S$) ou de la grandeur auxiliaire ($\Delta U_W$) qui en est dérivée au même multiple de la fréquence de rotation est déterminée pour plusieurs multiples de la fréquence de rotation et comparée avec un modèle théorique de la fonction de transfert.

**5.** Procédé selon l'une des revendications précédentes, selon lequel la grandeur mesurée est une tension ondulatoire ($U_W$).

**6.** Procédé selon la revendication 5, selon lequel la grandeur auxiliaire déterminée est une modification ($\Delta U_W$) de la tension ondulatoire ($U_W$) par rapport à une valeur de référence, une fonction de transfert entre une composante spectrale du flux de stator magnétique ($\Phi$) et une composante spectrale de la grandeur auxiliaire ($\Delta U_W$) au même multiple de la fréquence de rotation étant calculée pour plusieurs multiples de la fréquence de rotation, et la mesure dans laquelle au moins l'une des propriété suivantes, dérivées du modèle théorique, est réalisée étant déterminée :

- l'amplitude de la fonction de transfert présente un dépendance quadratique au multiple de la fréquence de rotation ;
- la phase de la fonction de transfert présente un dépendance linéaire au multiple de la fréquence de rotation.

**7.** Procédé selon l'une des revendications 1 à 4, selon lequel la grandeur mesurée est un flux annulaire ($\Phi_S$) le long d'une trajectoire fermée autour de l'arbre.

**8.** Procédé selon la revendication 7, selon lequel la grandeur auxiliaire utilisée est une modification du flux annulaire ($\Phi_S$) par rapport à une valeur de référence, une fonction de transfert entre une composante spectrale du flux de stator magnétique et une composante spectrale de la grandeur auxiliaire au même multiple de la fréquence de rotation étant calculée pour plusieurs multiples de la fréquence de rotation, et la mesure dans laquelle au moins l'une des propriété suivantes en tant que modèle théorique est réalisée étant déterminée :

- l'amplitude de la fonction de transfert présente un dépendance linéaire au multiple de la fréquence de rotation ;
- la phase de la fonction de transfert présente un dépendance linéaire au multiple de la fréquence de rotation.

**9.** Procédé selon l'une des revendications précédentes, selon lequel la grandeur auxiliaire utilisée est une variation de la grandeur mesurée par rapport à une valeur de référence.

**10.** Procédé selon la revendication 9, selon lequel des valeurs de référence de la grandeur mesuré ($U_W$ ; $\Phi_S$) sont déterminées à un instant de référence pour des états de charge de référence choisis de la machine électrique, puis stockées dans une mémoire, et la détermination de la grandeur auxiliaire étant effectuée en utilisant au moins une valeur de référence de la grandeur de mesure à un état de charge de référence qui est similaire à un état de charge momentané.

**11.** Procédé selon l'une des revendications précédentes, selon lequel le flux de stator magnétique ($\Phi$) est déterminé pendant la mise en oeuvre du procédé.

**12.** Procédé selon l'une des revendications 1 à 10, selon lequel des valeurs de référence du flux de stator magnétique ($\Phi$) sont déterminées à un instant de référence pour des états de charge de référence choisis de la machine électrique, puis stockées dans une mémoire, et la comparaison avec le modèle théorique est effectuée en utilisant au moins une valeur de référence du flux de stator magnétique ($\Phi$) à un état de charge de référence qui est similaire à un état de charge momentané.

**13.** Procédé selon l'une des revendications 1 à 12, selon lequel le flux de stator magnétique ($\Phi$) est déterminé par au moins une sonde de mesure magnétique (FS) qui est disposée dans un entrefer se trouvant entre le stator et le rotor ou dans le stator de la machine électrique.

**14.** Procédé selon l'une des revendications 1 à 12, selon lequel le flux de stator magnétique ($\Phi$) est déterminé mathématiquement à partir d'une tension aux bornes de la machine électrique et/ou à partir de paramètres de machine et de paramètres de charge de la machine électrique.

**15.** Dispositif pour mettre en oeuvre un procédé selon l'une des revendications précédentes, qui possède :

- un arrangement de mesure (6, 7, 10, 11) destiné à déterminer une grandeur mesurée qui est sensible à un courant de court-circuit provoqué par le flux de stator magnétique entre au moins deux tôles de stator ;
- une unité (12) destinée à déterminée le flux de stator magnétique à partir de données mesurées et/ou par calcul ;
- une unité d'interprétation (14) qui est configurée pour comparer la grandeur mesurée ou une grandeur auxiliaire qui en est dérivée avec un modèle théorique qui établit la relation entre la grandeur mesurée ou la grandeur auxiliaire et le flux de stator magnétique, et pour déterminer à partir de la comparaison au moins une valeur qui représente une mesure pour la présence d'un courant de court-circuit.

**16.** Dispositif selon la revendication 15, avec lequel l'unité d'interprétation (14) comprend un module de transformation (15) qui est configuré pour déterminer des composantes spectrales de la grandeur mesurée ou d'une grandeur auxiliaire qui en est dérivée, et avec lequel l'unité d'interprétation (14) est configurée pour comparer des composantes spectrales choisies de la grandeur mesurée ou d'une grandeur auxiliaire qui en est dérivée avec le modèle théorique.

**17.** Dispositif selon la revendication 15 ou 16, avec lequel la grandeur mesurée est une tension ondulatoire ($U_W$) et avec lequel l'arrangement de mesure (6, 7, 10, 11) comprend au moins deux brosses (6, 10) pour déterminer la tension ondulatoire ($U_W$) entre deux emplacements axiaux différents sur l'arbre (2).

**18.** Dispositif selon la revendication 15 ou 16, avec lequel la grandeur mesurée est un flux annulaire ($\Phi_S$) le long d'une trajectoire fermée autour de l'arbre (2) et avec lequel l'arrangement de mesure comprend au moins une sonde de mesure magnétique servant à déterminer le flux annulaire ($\Phi_S$).

**19.** Dispositif selon l'une des revendications 15 à 18, avec lequel l'unité destinée à déterminer le flux de stator magnétique comprend au moins une sonde de mesure magnétique (FS) servant à mesurer le flux de stator ($\Phi$).

**FIG. 1**

**FIG. 2**

**FIG. 3**

$U_{W1}$   $\Phi$   $U_{W2}$

PWR

$W(jn)$

**FIG. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5032826 A, Miller